Europäisches Patentamt

European Patent Office

Office européen des brevets

(19)

(11) Numéro de publication: **0 245 169**
**A1**

(12) **DEMANDE DE BREVET EUROPEEN**

(21) Numéro de dépôt: **87401017.6**

(22) Date de dépôt: **04.05.87**

(51) Int. Cl.⁴: **H 01 L 31/10**
**H 01 L 31/02**

(30) Priorité: **07.05.86 FR 8606614**

(43) Date de publication de la demande:
**11.11.87 Bulletin 87/46**

(84) Etats contractants désignés:
**DE ES FR GB IT NL**

(71) Demandeur: **SAT Société Anonyme de Télécommunications**
**41, rue Cantagrel**
**F-75631 Paris Cedex 13 (FR)**

(72) Inventeur: **Carpentier, Yves**
**25 rue du Bel Air**
**F-91600 Savigny Sur Orge (FR)**

**Royer, Michel**
**29 Rue Claude decaen**
**F-75012 Paris (FR)**

(74) Mandataire: **Bloch, Gérard et al**
**6, rue du Faubourg Saint-Honoré**
**F-75008 Paris (FR)**

(54) **Photodiode à avalanche HgCdTe.**

(57) Dans un cristal (1) de $Hg_{1-x}Cd_xTe$, on choisit x pour la réponse spectrale désirée, on réalise une jonction PN à faibles concentrations au voisinage de la jonction, par pénétrations d'impuretés à partir d'une surface (10) polie et attaquée chimiquement, et on éclaire la zone P (6). Le courant d'obscurité de la photodiode est inférieur à 0,1 Å/cm² à température ambiante. Le facteur excédentaire de bruit est inférieur à 0,4.

La photodiode de l'invention est utilisée pour la détection des signaux transmis sur des fibres optiques en verre fluoré, par exemple.

FIG.4

EP 0 245 169 A1

**Description**

Photodiode à avalanche HgCdTe.

La présente invention a pour objet une photodiode prévue pour une utilisation en régime d'avalanche à la température ambiante, et comprenant une jonction PN entourée d'un anneau de garde et réalisée dans un cristal de $Hg_{1-x}Cd_xTe$.

Une telle photodiode peut être utilisée, par exemple, pour la réception de signaux optiques se propageant sur des fibres optiques. En effet, le régime d'avalanche permet de bénéficier de la multiplication, par avalanche, du photocourant, ce qui confère à la photodiode une bonne sensibilité. Par ailleurs, le fonctionnement à température ambiante rend possible une mise en oeuvre qui serait trop lourde avce une photodiode devant être refroidie.

On connaît déja, par le brevet français No. 81 04 712 des photodiodes de ce type, dont la sensibilité maximale correspond à une longueur d'onde située entre 0,8 μm et 2 μm.

Ces photodiodes connues ne sont donc pas adaptées à une utilisation avec des fibres optiques en verre fluoré qui présenteront théoriquement dans la bande spectrale située entre 2 et 4 μm, des pertes extrêmement faibles, de l'ordre de $10^{-3}$dB/km, et qui devraient permettre la réalisation de liaisons de plusieurs centaines de kilomètres sans récepteurs.

Afin d'obtenir une photodiode $Hg_{1-x}Cd_xTe$ sensible dans une certaine bande spectrale, il est connu d'ajuster la fraction molaire x du matériau que l'on utilise. En effet, la fraction molaire x commande la largeur de la bande interdite, ou "gap" du matériau, et, donc, sa réponse spectrale. Ainsi, on connaît, par le brevet US 4 137 544 une photodiode $Hg_{1-x}Cd_xTe$ dont la fraction molaire x est choisie égale à 0,2, de façon à ce que la réponse spectrale de la photodiode corresponde à la gamme 8-14 μm. Pour cette valeur de la fraction molaire x, la largeur de la bande interdite est trop faible pour permettre un fonctionnement à température ambiante. Une tell photodiode necessite donc un dispositif de refroidissement. Comme cela est connu, il en est d'ailleurs ainsi pour toutes les photodiodes $Hg_{1-x}Cd_xTe$ dont la fraction molaire est inférieure à sensiblement 0,35. De plus, cette diode n'est pas prévue pour fonctionner en régime d'avalanche, notamment parce qu'elle ne comporte pas d'anneau de garde autour de la jonction PN.

Une photodiode $Hg_{1-x}Cd_xTe$, dont la fraction molaire x est choisie égale à 0,4 de façon à ce que la réponse spectrale soit centrée sur 2,7 μm, est décrite par S.H.SHIN et al. dans "High performance epitaxial Hg Cd Te photodiode for 2.7 μm Applications", IEEE Electron Devices Letters, vol. EDL-2, No. 7, July 1981, pages 177-179, New York U.S.A. Cette photodiode fonctionne à température ambiante, mais elle n'est pas prévue pour fonctionner en régime d'avalanche, notamment parce qu'elle ne comporte pas d'anneau de garde.

La modification des deux photodiodes précédentes afin de pouvoir les faire fonctionner en régime d'avalanche n'est pas, en particulier à cause de dopages de leurs zones P et N, envisageable à priori, compte-tenu du fait que la polarisation, dans la région d'avalanche, d'une jonction de faible largeur de bande interdite, conduit à la création d'un courant d'obscurité dû à l'effet tunnel trop important pour permettre un fonctionnement satisfaisant de la photodiode. Ce problème est en particulier signalé par HIROAKI ANDO et al. dans l'article "InGaAs/InP Separated Absorption and Multiplication Regions Avalanche Photodiode Using Liquid- and Vapor-Phase Epitaxies" p. 250-254 IEEE Journal of Quantun Electronics Vol QE-17, No. 2, February 1981.

Afin de surmonter les problèmes précédents, l'art antérieur enseigne d'abandonner les photodiodes classiques au profit de photodiodes à région d'absorption et de multiplication séparées. Dans ces photodiodes, les photons sont absorbés dans un matériau de faible largeur de bande interdite. Les paires électron-trou ainsi crées diffusent jusqu'à la jonction située dans un matériau de largeur de bande interdite plus grande. La jonction est polarisée dans la région d'avalanche pour multiplier le photocourant crée dans la région de faible largeur de bande interdite. Une telle photodiode est cependant de conception et de fabrication complexe.

La présente invention vise à pallier les inconvénients précédents en procurant une photodiode à avalanche, à une seule jonction PN, pour utilisation à température ambiante dans la gamme 2-4 μm. Elle associe dans un seul dispositif la fonction détection et la fonction préamplification.

A cet effet, elle a pour objet une photodiode du type défini ci-dessus, caractérisée par le fait que :
- la fraction molaire x est comprise entre sensiblement 0,35 et sensiblement 0,5,
- la zone N a une concentration en porteurs N inférieure ou égale à $2.10^{15}/cm^3$,
- la zone P a une concentration en porteurs P inférieure ou égale à $10^{16}/cm^3$ et reçoit le rayonnement à détecter,et,
- la jonction PN est obtenue par pénétration d'impuretés à partir d'une surface polie et attaquée chimiquement.

Dans la photodiode de l'invention, la demanderesse prévoit un anneau de garde qui permet, comme cela est connu, un fonctionnement en régime d'avalanche. Toutefois, elle choisit la fraction molaire x en fonction de la réponse spectrale, c'est-à-dire ici pour correspondre à une largeur faible de la bande interdite, allant ainsi à l'encontre des préjugés de l'art antérieur concernant le régime d'avalanche dans ce cas. Grâce à un faible dopage au voisinage de la jonction, et à un traitement de surface, il s'avère que les courants parasites, et en particulier le courant lié à l'effet tunnel, sont assez faibles pour permettre un bon fonctionnement. De plus, l'éclairage de la zone P permet de bénéficier d'un faible facteur de bruit excédentaire, car pour les valeurs de la

2

fraction molaire x considérée, le coefficient d'ionisation des électrons $\alpha$ est beaucoup plus grand que le coefficient d'ionisation des trous $\beta$ Ainsi le facteur de multiplication du photocourant peut être relativement important et les performances globales satisfaisantes.

Avantageusement,
- la zone N a une concentration en porteurs N supérieure ou égale à $5.10^{14}/cm^3$,
- la zone P a une concentration en porteurs P supérieure ou égale à $10^{15}/cm^3$.

Avantageusement encore, ladite surface à partir de laquelle on fait pénétrer les impuretés subit les polissages et attaques chimiques suivants :
- polissage à l'alumine de granulométrie 0,02 $\mu$m pendant une heure,
- polissage mécano-chimique à l'alumine de granulométrie 0,02 $\mu$m dans une solution à 25 g/l de $CrO_3$ pendant une heure, et,
- attaque chimique à l'acide chlorhydrique.

Dans une première forme de réalisation, le cristal de $Hg_{1-x}Cd_xTe$ est un cristal massif obtenu par procédé THM (Travelling Heater Method).

Dans une deuxième forme de réalisation le cristal de $Hg_{1-x}Cd_xTe$ est un cristal obtenu par épitaxie à partir d'un substrat semiconducteur.

La présente invention sera mieux comprise à la lecture de la description suivante de deux modes de réalisation de la photodiode selon l'invention, faite en référence aux dessins annexés, sur lesquels :

- les figures 1 à 4 illustrent les différentes phases d'un premier procédé de fabrication de la photodiode selon l'invention, et

- les figures 5 à 8 illustrent les différentes phases d'un deuxième procédé de fabrication de la photodiode selon l'invention.

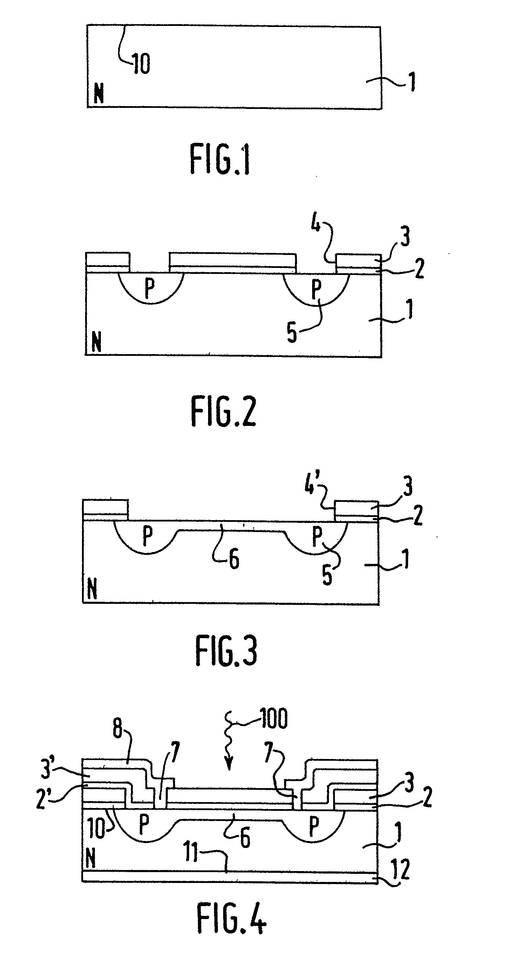

La photodiode à avalanche de l'invention est réalisée dans un cristal d'un alliage de mercure, de cadmium et de tellure $Hg_{1-x}Cd_xTe$, dans lequel la fraction molaire x est, à l'intérieur de la game 0,35-0,5, ajustée à une valeur correspondant à la sensibilité maximale désirée de la photodiode, dans la gamme 2-4 $\mu$m, comme cela est indiqué dans le brevet français N° 81 04 712, au nom de la demanderesse. Dans un premier mode de réalisation, pour fabriquer la photodiode, on part d'un substrat massif 1, représenté sur la figure 1.

Pour obtenir ce substrat 1, on fabrique un lingot de $Hg_{1-x}Cd_xTe$ par le procédé dit THM (Travelling Heater Method) décrit dans le bevet français N° 81 05 387 au nom de la demanderesse. On obtient ainsi un lingot présentant un caractère électronique de type P, qui est découpé en disques de 500 $\mu$m d'épaisseur. Chaque disque est soumis à une température de 300°C sous pression de vapeur saturante de mercure pendant une durée de deux mois, afin d'être converti en matériau de type N. On obtient ainsi un substrat 1 de type N dans lequel la concentration en porteur N est faible, et typiquement comprise entre $5.10^{14}$ et $2.10^{15}/cm^3$ à la température ambiante.

La face supérieure 10, sur la figure 1, du substrat 1 à partir de laquelle sera ensuite préparée, par diffusion, la jonction PN, subit d'abord un pré-polissage à l'alumine de granulométrie 0,3 $\mu$m pendant une heure, puis les polissages et attaques chimiques suivants :
- polissage à l'alumine de granulométrie 0,02 $\mu$m pendant une heure
- polissage mécano-chimique à l'alumine de granulométrie 0,02 $\mu$m dans une solution de 25 g/l de $CrO_3$ pendant une heure, et
- attaque chimique à l'acide chlorhydrique.

Après ces traitements, la surface de la face 10 du substrat 1 ne présente plus de défauts apparents en observation au microscope électronique à balayage, en mode de courant induit.

Sur la face 10, on dépose, ici par pulvérisation cathodique, une couche de masquage double. On dépose d'abord une couche 2 de CdTe, puis sur la couche 2 une couche 3 de ZnS, ou de $SiO_2$. Ces couches sont déposées à une vitesse de 250 Å/mn pour le CdTe et de 100 Å/mn pour le ZnS ou le $SiO_2$.

Comme le montre la figure 2, on ouvre ensuite, dans les couches de masquage 2 et 3, une fenêtre 4 de diffusion pour la réalisation d'un anneau de garde 5. La fenêtre 4 est réalisée par attaque chimique. Ainsi, le ZnS est attaqué par de l'acide chlohydrique concentré, le $SiO_2$ par de l'acide fluorhydrique et le CdTe par une solution de brome et de méthanol à 0,1 %.

L'anneau de garde 5, de type P, est ensuite réalisé par diffusion d'or sous pression de vapeur saturante de mercure à 300°C, pendant une durée de 8 heures, de façon à obtenir une concentration en porteurs P comprise entre $10^{15}$ et $10^{16}/cm^3$. On pourrait également réaliser l'anneau de garde 5 par diffusion de phosphore, ou d'arsenic.

Comme le montre la figure 3, on supprime ensuite, par attaque chimique, les parties des couches 2 et 3 intérieures à la fenêtre 4 de façon à former une fenêtre 4' de diffusion d'une zone 6 de type P, c'est-à-dire ici de la surface sensible de la photodiode.

Cette zone 6 est réalisée par diffusion d'or sous pression de vapeur saturante de mercure à 300°C, pendant une durée de 2 heures, de façon à obtenir une concentration en porteurs P comprise entre $10^{15}$ et $10^{16}/cm^3$, sur une épaisseur inférieure à celle de l'anneau de garde 5. Là encore, on pourrait diffuser, au lieu d'or, du phosphore ou de l'arsenic.

Comme le montre la figure 4, on dépose ensuite une couche de passivation double. Une couche 2' de CdTe est déposée dans les mêmes conditions que la couche 2. Une couche 3' de ZnS, ou de $SiO_2$, est déposée dans les mêmes conditions que la couche 3.

Ensuite, on pratique des ouvertures dans les couches 2' et 3' par attaque chimique, et on métallise ces ouvertures par dépôt, par exemple par pulvérisation cathodique, de platine, puis d'or pour réaliser des contacts 7. Le platine est déposé à une vitesse de 100 Å/mn et l'or à une vitesse de 250 Å/mn. La totalité de la surface supérieure se trouve alors recouverte d'une couche métallique de platine et d'or, dont on enlève la majeure partie pour ne laisser subsister que des métallisations 8 nécessaires à l'établissement des connexions, au cours d'une opération de gravure. L'opération de gravure est réalisée en recouvrant tout d'abord les zones destinées à devenir les métallisations 8 par une résine protectrice, par un procédé connu. Ensuite, on élimine la couche métallique non protégée par pulvérisation inverse sous plasma d'argon, c'est-à-dire que la couche métallique est bombardée par des ions d'argon afin que sous l'action de ce bombardement, le métal se trouve pulvérisé et se détache de la surface de la photodiode. La vitesse à laquelle la couche de métal diminue d'épaisseur est de 50 Å/mn. Cette vitesse lente permet une gravure sans risque d'endommager la photodiode réalisée.

Le substrat 1 est ensuite aminci par rodage à l'alumine de granulométrie 0,3 μm de sa face inférieure 11 sur la figure 4. La face 11 est ensuite métallisée par pulvérisation cathodique d'une couche 12 de platine et d'or, dans les mêmes conditions que précédemment.

La photodiode ainsi obtenue est montée dans un boîtier non représenté, prévu pour que les photons 100 à détecter éclairent la zone P, comme cela est montré sur la figure 4.

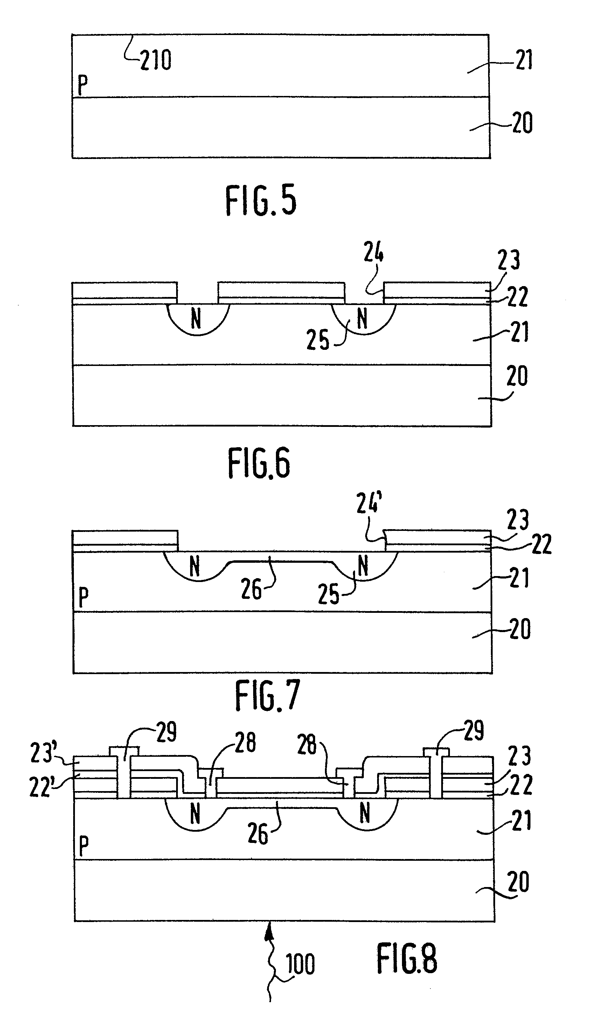

Dans un deuxième mode de réalisation, pour fabriquer la photodiode, on part, en référence à la figure 5, d'un cristal 21 de $Hg_{1-x}Cd_xTe$ obtenu par croissance épitaxiale à partir d'un substrat 20 semi-conducteur, ici et par exemple en CdTe monocristallin, orienté 111.

Pour faire croître le cristal 21 de $Hg_{1-x}Cd_xTe$ on emploie une des techniques de croissance par épitaxie connues, par exemple :
- la croissance LPE (Liquid Phase Epitaxy)
- la croissance MBE (Molecular Beam Epitaxy)
- la croissance MOCVD (Metallo-Organic-Chemical Vapor Deposition)

On fait ainsi croître un cristal 21 de $Hg_{1-x}Cd_xTe$ d'épaisseur typiquement égale à 20 μm et de concentration en porteurs P typiquement comprise entre $10^{15}$ et $10^{16}/cm^3$. La face supérieure 210 sur la figure 5 du cristal 21, est alors soumise aux polissages et attaques chimiques suivants :
- polissage à l'alumine de granulométrie 0,02 μm pendant une heure,
- polissage mécano-chimique à l'alumine de granulométrie 0.02 μm dans une solution de 25 g/l de $CrO_3$ pendant une heure, et,
- attaque chimique à l'acide chlorhydrique.

Après ces traitements de surface, on dépose des couches de masquage 22 et 23 de compositions identiques à celles des couches 2 et 3, et dans des conditions identiques.

Comme le montre la figure 6, on ouvre ensuite, dans les couches de masquage 22 et 23, une fenêtre 24 pour réaliser un anneau de garde 25. La fenêtre 24 est réalisée par attaque chimique.

L'anneau de garde 25, de type N, est ensuite réalisé par diffusion de mercure sous pression de vapeur saturante de mercure à 300°C, pendant une durée de 8 heures, afin d'obtenir une concentration en porteurs N comprise entre $5.10^{14}$ et $2.10^5/cm^3$ à température ambiante.

Comme le montre la figure 7, on supprime ensuite, par attaque chimique les parties des couches 22 et 23 intérieures à la fenêtre 24 de façon à former une fenêtre 24′, de diffusion d'une zone 26 de type N, c'est-à-dire ici la surface sensible de la photodiode.

Cette zone 26 est réalisée par implantation d'ions $Al^{2+}$ sous 60 keV à raison de $10^{14}$ ions par $cm^2$, suivie d'un recuit sous pression de vapeur saturante de mercure à 300°C, pendant une durée de 2 heures. On obtient ainsi une concentration en porteurs N comprise entre $5.10^{14}$ et $2.10^{15}/cm^3$ à température ambiante.

Comme le montre la figure 8, on dépose ensuite des couches de passivation 22′ et 23′, de composition identique à celles des couches 2′ et 3′, et dans les mêmes conditions.

On réalise ensuite des contacts 28 d'accès à la zone N et des contacts 29 d'accès à la zone P en procédant comme pour la réalisation des contacts 7. De même, des métallisations, non représentées sur la figure 8 dans un souci de simplicité, sont réalisées.

La photodiode ainsi obtenue est montée dans un boîtier prévu pour que les photons 100 à détecter éclairent la zone P. A cet effet, l'épaisseur, de l'ordre de 20 μm, de la zone épitaxiée 21 a été choisie pour permettre une absorption complète des photons au voisinage de la jonction.

Les photodiodes ainsi obtenues présentent un faible courant d'obscurité inférieur à 0,1 $A/cm^2$, car la qualité du cristal de $Hg_{1-x}Cd_xTe$, le contrôle rigoureux des états de surface et les faibles dopages mis en oeuvre font que les concentrations au voisinage de la jonction sont faibles, ce qui a pour effet de réduire le courant d'obscurité lié à l'effet tunnel.

Par ailleurs, le facteur excédentaire de bruit x (à ne pas confondre avec la fraction molaire x) lié à la multiplication par avalanche est faible. Ceci est dû au fait que, pour la gamme de fractions molaires visées, le rapport entre le coefficient d'ionisation des trous β et le coefficient d'ionisation des électrons α est très inférieur à 1 et que la photodiode est éclairée du côté P.

Dans l'article "$Ga_{1-x}Al_xSb$ Avalanche Photodiodes : Resonant Impact Ionization with Very High Ratio of Ionization Coefficients" de HILDEBRAND et al, dans la revue "IEEE Journal of Quantum Electronics" Vol QE-17, N° 2, February 1981, il est décrit un procédé pour réduire le facteur de bruit excédentaire dans lequel on choisit une longueur d'onde de fonctionnement pour laquelle β est très supérieur à α, la diode étant éclairée par la zone N. La demanderesse, ayant constaté que dans un cristal de $Hg_{1-x}Cd_xTe$ de composition

correspondant à une longueur d'onder de coupure supérieure à 2 μm, le rapport $\beta / \alpha$ était très inférieur à 1, elle a choisi d'éclairer la zone P our bénéficier à la fois d'un facteur de multiplication élevé et d'un facteur excédentaire de bruit faible.

A titre d'exemple, les caractéristiques d'une photodiode à avalanche réalisée selon le premier mode de réalisation sont les suivantes :

```
- Fraction molaire                          0,5
- Longueur d'onde de coupure                2,5 μm
- Surface sensible                          5.10⁻⁵cm²
- Tension d'avalanche                       -28 V
- Facteur multiplicatif (V = -28 V)         10
                                            ⎧ 50nA à 25°C
- Courant de saturation (V = -1V)           ⎨
                                            ⎩  1nA à -20°C
- Courant d'obscurité (V = -10V)              200 nA

- Facteur excédentaire de bruit
                        (V = -28V)                    0,4
- Capacité totale (V = -10V)                          1pF
- Réponse en courant (λ = 2,2 μm et V = -1V)      1,2 A/W
```

On notera le courant d'obscurité particulièrement bas, et le fait que la réponse en courant, pour V = -IV, est comparable à celle obtenue dans les photodiodes de l'art antérieur, qui, elles, ne peuvent fonctionner en régime d'avalanche. Ainsi, compte tenu du facteur multiplicatif de 10 obtenu en régime d'avalanche, pour la photodiode de l'invention, tout se passe comme si celle-ci était dix fois plus sensible. On notera également que ce résultat est obtenu sans une augmentation trop importante du bruit, puisque le facteur excédentaire de bruit reste faible.

## Revendications

1.- Photodiode prévue pour une utilisation en régime d'avalanche à la température ambiante, et comprenant une jonction PN entourée d'un anneau de garde et réalisée dans un cristal (1;21) de $Hg_{1-x}Cd_xTe$), caractérisée par le fait que:
- la fraction molaire x est comprise entre sensiblement 0,35 et sensiblement 0,5,
- la zone N (1;26) a une concentration en porteurs N inférieure ou égale à $2.10^{15}/cm^3$,
- la P (6;21) a une concentration en porteurs P inférieure ou égale à $10^{16}/cm^3$ et reçoit le rayonnement à détecter (100), et,
- la jonction PN est obtenue par pénétration d'impuretés à partir d'une surface (10;210) polie et attaquée chimiquement.

2.- Photodiode selon la revendication 1, dans laquelle :
- la zone N (1;26) a une concentration en porteurs N supérieure ou égale à $5.10^{14}/cm^3$,
- la zone P (6;21) a une concentration en porteurs P supérieure ou égale à $10^{15}/cm^3$.

3.- Photodiode selon l'une des revendications 1 ou 2, dans laquelle ladite surface (10;210), à partir de laquelle on fait pénétrer les impuretés, subit les polissages et attaques chimiques suivants :
- polissage à l'alumine de granulométrie 0,02 μm pendant une heure,
- polissage mécano-chimique à l'alumine de granulométrie 0,02 μm dans une solution à 25 g/l de $CrO_3$ pendant une heure, et,
- attaque chimique à l'acide chlorhydrique.

4.- Photodiode sleon l'une des revendications 1 à 3, comprenant des couches de masquage et de passivation dont chacune est double et comprend une première couche (2,2' ; 22,22') de CdTe et une deuxième couche (3,3' ; 23,23') de l'un des matériaux ZnS et $SiO_2$.

5.- Photodiode selon l'une des revendications 1 à 4, dans laquelle le cristal (1) de $Hg_{1-x}Cd_xTe$ est un cristal massif obtenu par procédé THM (Travelling Heater Method).

6.- Photodiode selon la revendication 5, dans laquelle ladite surface (10) du cristal (1) à partir de laquelle on fait pénétrer les impuretés subit, avant polissage et attaque chimique, un pré-polissage à l'alumine de granulométrie 0,3 µm pendant une heure.

7.- Photodiode selon l'une des revendications 5 ou 6, dans laquelle la zone N est obtenue en soumettant le cristal (1) à une température de 300°C sous pression de vapeur saturante de mercure.

8.- Photodiode selon l'une des revendications 5 à 7, dans laquelle la zone P est obtenue par diffusion d'or sous pression de vapeur saturante de mercure à 300°C.

9.- Photodiode selon l'une des revendicaitons 1 à 4, dans laquelle les cristal (21) de $Hg_{1-x}Cd_xTe$ est un cristal obtenu par épitaxie à partir d'un substrat (20) semi-conducteur.

10.- Photodiode selon la revendication 9, dans laquelle la zone N est obtenue par implantation ionique d'ions $Al^{2+}$.

0245169

FIG.1

FIG.2

FIG.3

FIG.4

0245169

FIG.5

FIG.6

FIG.7

FIG.8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 045 258  (S.A. DE TELECOMMUNICATIONS) * En entier * | 1,2,7, 10 | H 01 L  31/10 H 01 L  31/02 |
| A | | 4,5 | |
| | --- | | |
| D,Y | US-A-4 137 544  (T. KOEHLER) * En entier * | 1,2,7, 10 | |
| D,A | | 8 | |
| | --- | | |
| A | EP-A-0 060 743  (S.A. DE TELECOMMUNICATIONS) * Page 1, ligne 1 - page 3, ligne 23; page 4, ligne 8 - page 5, ligne 25; revendications; figures 1-6 * | 1,2,4, 5,7,10 | |
| A | IEEE TRANSACTIONS ON ELECTRON DEVICES, vol. ED-32, no. 7, juillet 1985, pages 1302-1306, IEEE, New York, US; R. ALABEDRA et al.: "An Hg0.3Cd0.7Te avalanche photodiode for optical-fiber transmission systems at lambda = 1.3 mum" * Page 1302; figure 1; page 1303; deuxième colonne * | 1-3,5, 7,10 | |
| | ---                -/- | | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 18-06-1987 | VISENTIN A. |

| | **DOCUMENTS CONSIDERES COMME PERTINENTS** | | Page  2 |
|---|---|---|---|
| Catégorie | Citation du document avec indication, en cas de besoin. des parties pertinentes | Revendication concernée | CLASSEMENT DE LA DEMANDE (Int. Cl.4) |
| D,A | IEEE ELECTRON DEVICE LETTERS, vol. EDL-2, no. 7, juillet 1981, pages 177-179, IEEE, New York, US; S.H. SHIN et al.: "High performance epitaxial HgCdTe photodiodes for 2.7 mum applications" * En entier * | 1,2,9 | |
| A | APPLIED PHYSICS LETTERS, vol. 23, no. 8, 15 octobre 1973, pages 450-452, American Institute of Physics, New York, US; J. MARINE et al.: "Infrared photovoltaic detectors for ion-implanted CdxHg1-xTe" | | |
| A | OPTICAL ENGINEERING, vol. 16, no. 3, mai-juin 1977, pages 237-240, Bellingham, GB; T.J. TREDWELL: "(Hg,Cd)Te Photodiodes for detection of two-micrometer infrared radiation" | | DOMAINES TECHNIQUES RECHERCHES (Int. Cl.4) |

Le présent rapport de recherche a été établi pour toutes les revendications

| Lieu de la recherche | Date d'achèvement de la recherche | Examinateur |
|---|---|---|
| LA HAYE | 18-06-1987 | VISENTIN A. |